**Europäisches Patentamt**

**European Patent Office**

**Office européen des brevets**

(19)

(11) Veröffentlichungsnummer: **0 313 765 B1**

(12) **EUROPÄISCHE PATENTSCHRIFT**

(45) Veröffentlichungstag der Patentschrift: **26.08.92**

(21) Anmeldenummer: **88114310.1**

(22) Anmeldetag: **02.09.88**

(51) Int. Cl.⁵: **G01R 23/00**

(54) **Verfahren und Anordnung zur Bestimmung der Momentanfrequenz eines Signals.**

(30) Priorität: **26.10.87 DE 3736124**

(43) Veröffentlichungstag der Anmeldung:
**03.05.89 Patentblatt 89/18**

(45) Bekanntmachung des Hinweises auf die
Patenterteilung:
**26.08.92 Patentblatt 92/35**

(84) Benannte Vertragsstaaten:
**DE ES FR GB IT NL SE**

(56) Entgegenhaltungen:
**EP-A- 0 243 771**
**GB-A- 2 027 297**

**MICROWAVE JOURNAL, Band 28, Nr. 2, Februar 1985, Seiten 147-152, Dedham, Massachusetts, US; R. BAUMAN: "Digital instantaneous frequency measurement for EW receivers"**

(73) Patentinhaber: **TELEFUNKEN SYSTEMTECHNIK GMBH**
**Sedanstrasse 10**
**W-7900 Ulm (Donau)(DE)**

(72) Erfinder: **Zimmer, Manfred, Dr.**
**Pappelauer Weg 25**
**W-7900 Ulm(DE)**

(74) Vertreter: **Schulze, Harald Rudolf, Dipl.-Ing. et al**
**TELEFUNKEN SYSTEMTECHNIK GMBH Sedanstrasse 10**
**W-7900 Ulm(DE)**

## Beschreibung

Die Erfindung betrifft ein Verfahren und eine Anordnung zur Bestimmung der Momentanfrequenz eines Signals nach dem Oberbegriff des Patentanspruchs 1.

Ein derartiges Verfahren ist beispielsweise aus Microwave Journal, Vol. 28, No. 2 (Febr. 1985), S. 147-154 bekannt. Zur schnelleren Detektion von hohen und sehr hohen Frequenzen (f>1GHz) kommen im wesentlichen nur spezielle Parallelverfahren insbesondere nach dem sogenannten "Interferometerprinzip" (Ursprung aus der Optik: Kohärente Überlagerung von phasenverschobenen Wellenzügen gleicher Frequenz und gleicher Amplitude) in Frage. Hierbei werden grundsätzlich zur Erzeugung der erforderlichen, frequenzproportionalen Phasendrehungen $\theta(f)$ des Eingangssignals s(t) eine oder mehrere Verzögerungsleitungen bzw. Verzögerungselemente benutzt. Der mathematische Zusammenhang zwischen Signallaufzeit $\tau$ und Signalphasendrehung $\theta$ auf einer homogenen, verlustlosen Verzögerungsleitung $D_i$ ist gegeben durch

$$\theta_i(f) = 2\pi f\tau \text{ mit } \tau = \tfrac{1}{\Delta f} \ (\Delta f = \text{Detektionsbandbreite})$$

und somit gilt für eine komplexe Eingangsamplitude $\overline{A}_i$ die komplexe Ausgangsamplitude

$$\overline{B}_i = \overline{A}_i \cdot e^{-j\theta i}$$

In die parallel angeordneten Verzögerungsleitungen müssen nach einer bestimmten mathematischen Vorschrift ausgewählte, frequenzunabhängige (konstante) Signalphasen $\overline{A}_i$ eingespeist werden, die aus dem Eingangssignal s(t) zu bilden sind. Die Erzeugung dieser Signalphasen $\overline{A}_i$ kann durch ein Mikrowellen-Streifenleiter-Netzwerk oder Hybridkoppler-Netzwerk geschehen.

Bei dem bekannten Verfahren wurden die eigentlichen Frequenz-Detektionen aus den parallelen, verzögerten Signalphasen $\overline{B}_i$ durch Frequenz-Diskriminator-Netzwerke bzw. Korrelatoren vorgenommen, die rein analoge Schaltungen darstellen. Hierzu werden weitere passive Phasenschieber-Netzwerke in Verbindung mit Hochfrequenz-Mischern verwandt, die durch spezielle Phasensummationen der verzögerten, komplexen Amplituden $\overline{B}_i$ mit anschließenden Signalmischungen (Quadratur-Mischungen) die Frequenzwertkomponenten $W_i$ bilden. Diese Frequenzwertkomponenten $W_i$ müssen nun durch Tiefpaßfilterung von den weiteren Mischprodukten (Harmonischen von s(t)) abgetrennt werden und durch nachfolgende Differenzbildungen, z.B. mit Video-Differenzverstärkern, derart miteinander kombiniert werden, daß damit die einzelnen, gewünschten, analogen Frequenzwerte W(f) entstehen. Danach erst kann im Tiefpaßbereich die eigentliche Digitalisierung der Frequenzwerte W(f) durch spezielle Analog/Digital-Umsetzer (ADU) bzw. Phasen/Digital-Umsetzer (PDU) erfolgen.

Bei dem bekannten Verfahren müssen also, trotz der parallelen Grundstruktur, die einzelnen Signale sehr lange Verarbeitungswege durch die vielen verschiedenen Komponenten nehmen, um bis zur Frequenzwertausgabe zu gelangen. Dies und vor allem die endliche Bandbreite ($B_v < 100$ MHz) der Differenzverstärker bedingen eine entsprechend große Ansprechzeit taq der Frequenzdetektoren. Sie liegt bei den herkömmlichen Verfahren bei taq > 70 ns und ist damit für die genaue Auswertung von Mikrowellenimpulsen der Dauer tp < 100 ns zu groß.

Die Nachfrage nach sehr schnellen digitalen Momentanfrequenzdetektoren (DMFD) ist aber für eine Echtzeit-Signalverarbeitung auf dem Gebiet des Satellitenfunks, des Satellitenfernsehens, des Raumfahrtfunks, des Richtfunks, der Radartechnik sowie für digitale Höchstfrequenzempfänger in allen kommerziellen und militärischen Bereichen stark im Wachsen begriffen. Dieser Trend wird durch das verstärkte Aufkommen von neuen, monolithisch integrierten Mikrowellenschaltkreisen (MMICs), insbesondere von digitalen Schaltkreisen (Gigabit-Logik) in GaAs-FET- und Hochgeschwindigkeits-ECL-Technologie noch maßgeblich unterstützt.

Der vorliegenden Erfindung liegt daher die Aufgabe zugrunde ein Verfahren zur Momentanfrequenzbestimmung für sehr hohe Frequenzen sowie eine Anordnung zur Durchführung eines solchen Verfahrens anzugeben.

Die Erfindung sowie vorteilhafte Ausführungen und Weiterbildungen davon können den Patentansprüchen entnommen werden.

Das erfindungsgemäße auf dem "Interferometerprinzip" beruhende reine Parallelverfahren zur digitalen Bestimmung von Momentanfrequenzen nutzt in besonderer Weise die mathematischen (orthogonalen) Eigenschaften der trigonometrischen Funktionen aus. Letztlich werden die Frequenz-Detektionen auf Vorzeichenbestimmungen von entsprechenden, phasenverschobenen (verzögerten) Signalsummen zurückgeführt. Zur Ausführung der Vorzeichenbestimmungen werden die Modulo-Additionen von Digitalsignalen mittels Exclusive-OR/NOR-Gatter herangezogen. Die hierfür benötigten Verarbeitungsvorschriften sind im Patentanspruch 1 angegeben.

Die einzelnen, durch die Vorschriften im Patentanspruch 1 umfaßten Signalverarbeitungsschritte wie Erzeugen definierter Signalverzögerungen und Phasendrehungen, Addition bzw. Subtraktion zweier Signale, Gewinnung eines Vorzeichensignals und 1-Bit-Modulo-Addition sind mit an sich bekannten, schnellen und einfach aufgebauten Baugruppen durchführbar. Besonders vorteilhafte Beispiele sind bei der Erläuterung der Abbildungen noch im einzelnen dargelegt. Durch die damit verbundene geringe Komplexität eignet sich eine Anordnung zur Durchführung des erfindungsgemäßen Verfahrens besonders auch zur Integration auf einem oder wenigen Halbleiterbausteinen. Die minimale Ansprechzeit taq liegt in der Größenordnung etwa der doppelten maximalen Verzögerungszeit in der Verzögerungseinheit, so daß eine extrem schnelle digitale Frequenz-Detektion von Hoch- und Höchstfrequenzimpulsen bis zu Pulsbreiten im Pikosekundenbereich möglich ist. Durch die prinzipielle Möglichkeit hoher Wortbreiten ist eine große Genauigkeit der Frequenzbestimmung möglich. Das erfindungsgemäße Verfahren arbeitet als reines Parallelverfahren mit der digitalen Frequenzdetektion direkt im Bandpaßbereich des Eingangssignals s(t). Anstelle der Mischstufen, Tiefpaßfilter und Differenzverstärker bekannter Anordnungen können Komparatoren und logische Gatter eingesetzt werden. Es erfolgt mit der Vorzeichenfunktion frühzeitig der Übergang auf digitale Signale und insbesondere stellen die Signale nach der 1-Bit-Modulo-Addition bereits die digitalen Frequenzwerte im gewählten Code dar, so daß keine speziellen Digitalisierstufen mehr erforderlich sind. Die Wahl der Kodierung, welche die Art der alternativ angegebenen Signalverarbeitungsvorschriften (gerade oder ungerade) für die einzelnen Kodestellen festlegt, ist im Prinzip frei, so daß beispielsweise sowohl Binär-Code als auch der Gray-Code oder ein gemischter Binär-Gray-Code gewählt werden können.

Die Erfindung ist nachfolgend anhand von Beispielen unter Bezugnahme auf die Abbildungen noch eingehend veranschaulicht. Dabei zeigt

FIG. 1    die prinzipielle Gliederung einer DMFD (Digitale Momentanfrequenz-Detektion)-Anordnung

FIG. 2    (A) eine Grundschaltung einer einzelnen Detektorzelle
          (B) dazugehörige Kennlinien
          für die gerade Signalverarbeitungsvorschrift

FIG. 3    (A) eine Grundschaltung einer einzelnen Detektorzelle
          (B) dazugehörige Kennlinien
          für die ungerade Signalverarbeitungsvorschrift

FIG. 4    analoge und digitale Kennlinienfunktionen der geraden (A) und ungeraden (B) Version für die Ableitung in Quotientenform

FIG. 5    analoge und digitale Kennlinienfunktionen der geraden (A) und ungeraden (B) Version für die Ableitung in Produktform

FIG. 6    den Aufbau einer Detektorzelle für die gerade Vorschrift

FIG. 7    den Aufbau einer Detektorzelle für die ungerade Vorschrift

FIG. 8    den Aufbau einer 4-Bit-DMFD-Anordnung für die Frequenzwertausgabe im Binär-Code

FIG. 9    zugehörige Kennlinien der einzelnen Detektorzellen (A) und Zuordnung der Bitwerte der Codestellen zu den Codewerten (B) des Kodierbereichs

FIG. 10   wie FIG. 8 für die Frequenzausgabe im Gray-Code

FIG. 11   wie FIG. 9 für die Anordnung nach FIG. 10

FIG. 12   wie FIG. 8 für die Frequenzausgabe im Binär-Gray-Mischcode

FIG. 13   wie FIG. 9 für die Anordnung nach FIG. 12.

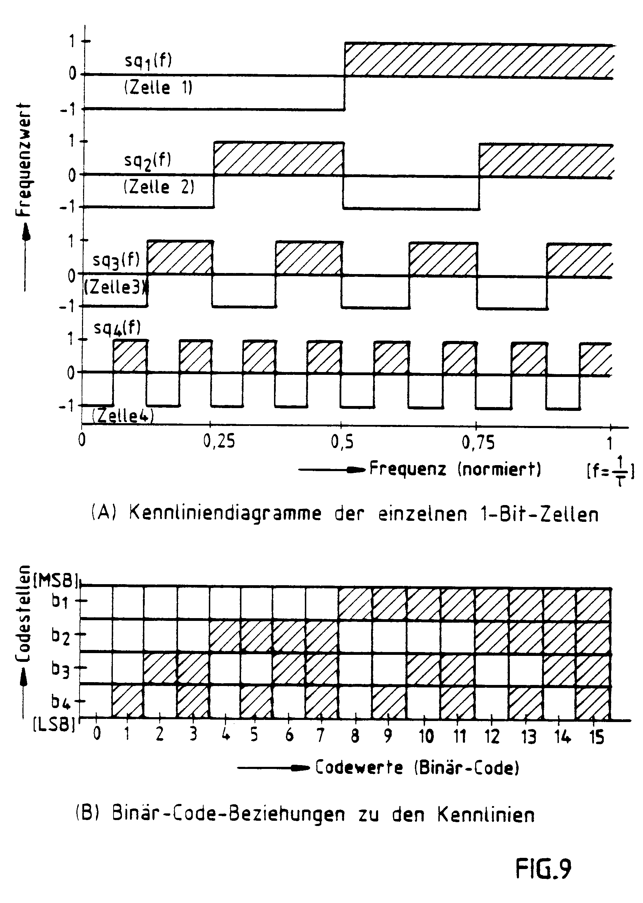

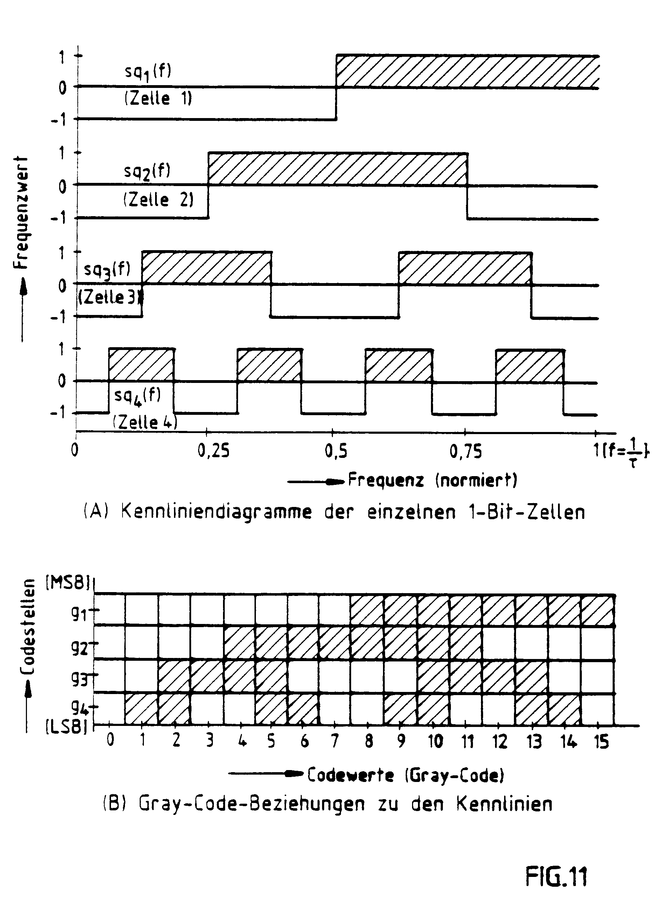

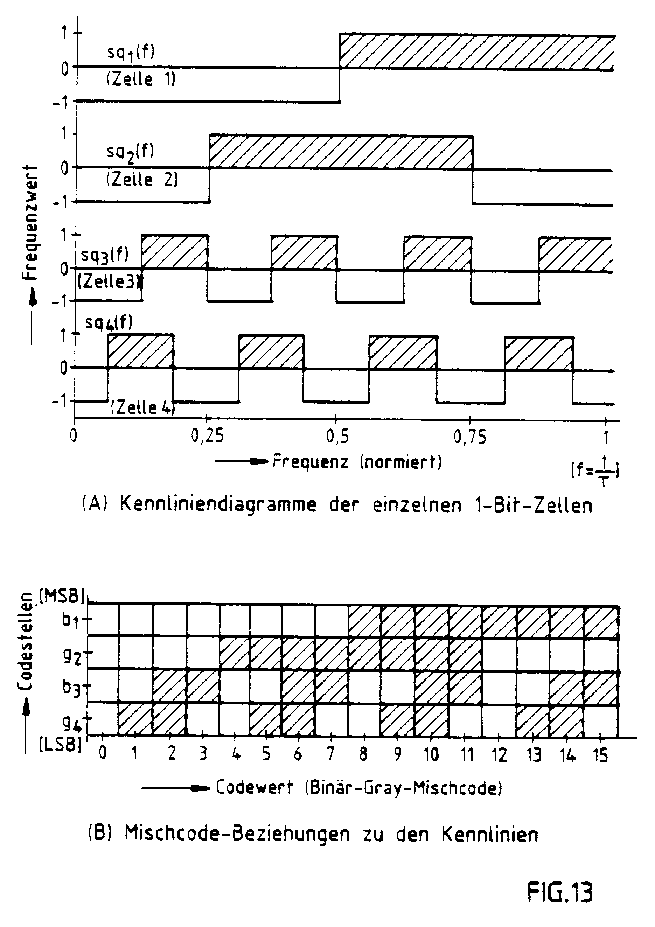

Die benutzten Begriffe der bezüglich der Kodierbereichsmitte geraden oder ungeraden Bitfunktion einer einzelnen Codestelle werden besonders anschaulich am Beispiel der FIG. 13 (B) für die 4-Bit-Kodierung im Binär-Gray-Mischcode mit den Codestellen b1 (MSB = höchstwertiges Bit), g2, b3 und g4 (LSB = geringstwertiges Bit). Schraffierte oder nichtschraffierte Felder repräsentieren den Zustand H bzw. L (oder + 1/-1) der jeweiligen Codestelle bei den verschiedenen Codewerten, die entsprechend der 4-Bit-Kodierung die Werte von 0 bis 15 umfassen. Die Mitte des Kodierbereichs liegt dann beim Übergang zwischen den Codewerten 7 und 8. Der Abbildung kann unmittelbar entnommen werden, daß die Codestellen b1 und b3 eine bezüglich der Bereichsmitte ungerade (oder antisymmetrische) Bitfunktion, die Codestellen g2 und g4 eine bezüglich der Bereichsmitte gerade (oder symmetrische) Bitfunktion aufweisen. Aus den Figuren 9(B) und 11(B) kann entsprechend entnommen werden, daß die Codestellen b1, b2, b3, b4, g1 ungerade, die Codestellen g2, g3 und g4 gerade Bitfunktionen besitzen. Die Einteilung ist für andere Wortlängen und andere Codes in entsprechender Weise leicht ersichtlich.

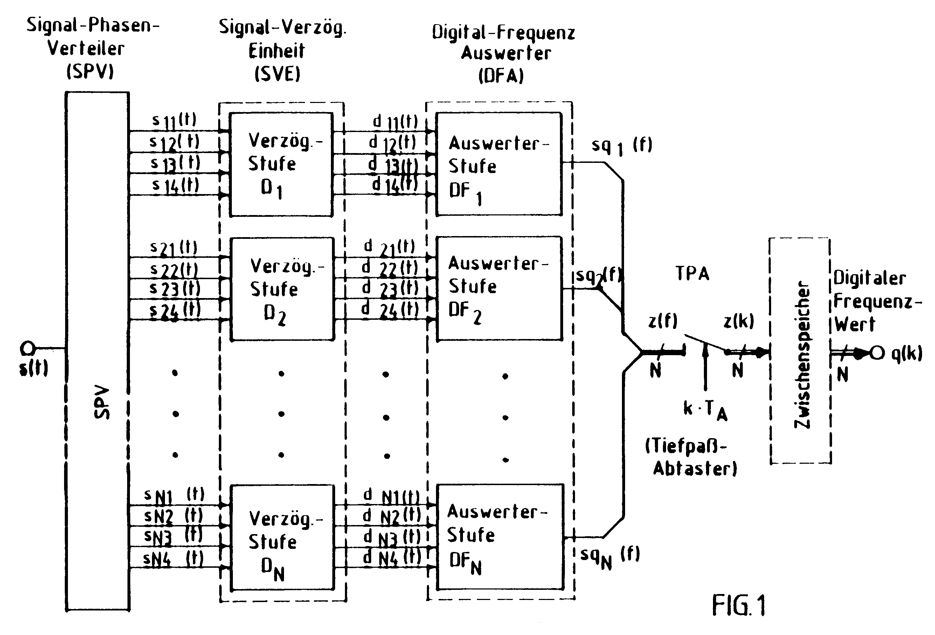

Gemäß FIG. 1 weist ein N-Bit digitaler Momentanfrequenz-Detektor für ein (vorgefiltertes und verstärktes) Eingangssignal s(t) nach dem neuen Verfahren im wesentlichen einen Signal-Phasen-Verteiler SPV auf, dem eine Signal-Verzögerungs-Einheit SVE und der wiederum der eigentliche Digital-Frequenz-Auswerter DFA nachgeschaltet ist. Hierbei liefert der SPV 4 mal N Signalphasen $s_{i,n}(t)$ (mit i = 1...N) an die SVE, sowie

EP 0 313 765 B1

die SVE ebenfalls 4 mal N verzögerte Signalphasen $d_{i,n}(t)$ an den DFA. Weiter gliedert sich die SVE in N Verzögerungsstufen $D_1$ bis $D_N$ und der DFA gleichermaßen in N Auswerterstufen $DF_1$ bis $DF_N$. Die verschiedenen Stufen $D_i$ bzw. $DF_i$ sind jeweils von ihrem prinzipiellen inneren Schaltungsaufbau her identisch. Jedoch müssen die Signallaufzeiten $T_i$ der Verzögerungsstufen $D_i$ nach der für die jeweilige Codestelle festgelegten Verarbeitungsvorschrift untereinander ganzzahlig gestaffelt werden. Die Ausgangssignale $sq_i$ der $DF_i$ stellen bereits die Bitwerte der einzelnen Codestellen des digitalen Momentanfrequenzwerts $z(f)$ dar. Ein anschließender Tiefpaß-Abtaster und Zwischenspeicher - realisierbar als Ausgabe-Register - ist zur Synchronisation der Frequenzwertsequenzen $sq_i(f)$ bzw. des Digitalwertes $z(f)$ auf einen Systemtakt $k.TA$ zur Weiterverarbeitung als digitaler Frequenzwert $q(k)$ vorgesehen. Jedoch ist dieser an sich bekannte Tiefpaß-Abtaster mit Zwischenspeicher nicht Gegenstand der vorliegendenden Erfindung.

Die Bildung der einzelnen Bits (Sequenzen $sq_1(f)$ bis $sq_n(f)$ der digitalen Frequenzwerte erfolgt jeweils durch die Reihenschaltung der entsprechenden Verzögerungsstufe $D_i$ mit der entsprechenden Auswerter-Stufe $DF_i$. Diese Serienschaltung $(D_i, DF_i)$ stellt somit die eigentliche Detektorzelle der DMFD-Anordnung dar und liegt folglich für eine N-Bit-Frequenzdetektion N mal vor. Hierbei ist jedoch die Dimensionierung der inneren Signallaufzeit $T_i$ und eventuell auch die Phasenlage der Signalphasen $s_{i,n}(t)$ von Detektorzelle zu Detektorzelle unterschiedlich zu wählen und ein entsprechender SPV am Signaleingang vorzusehen.

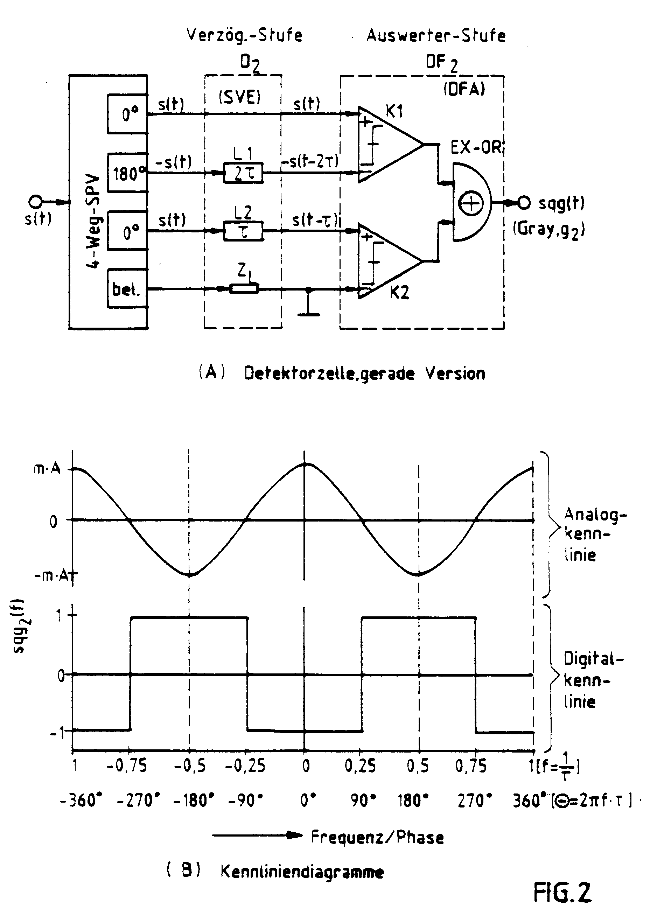

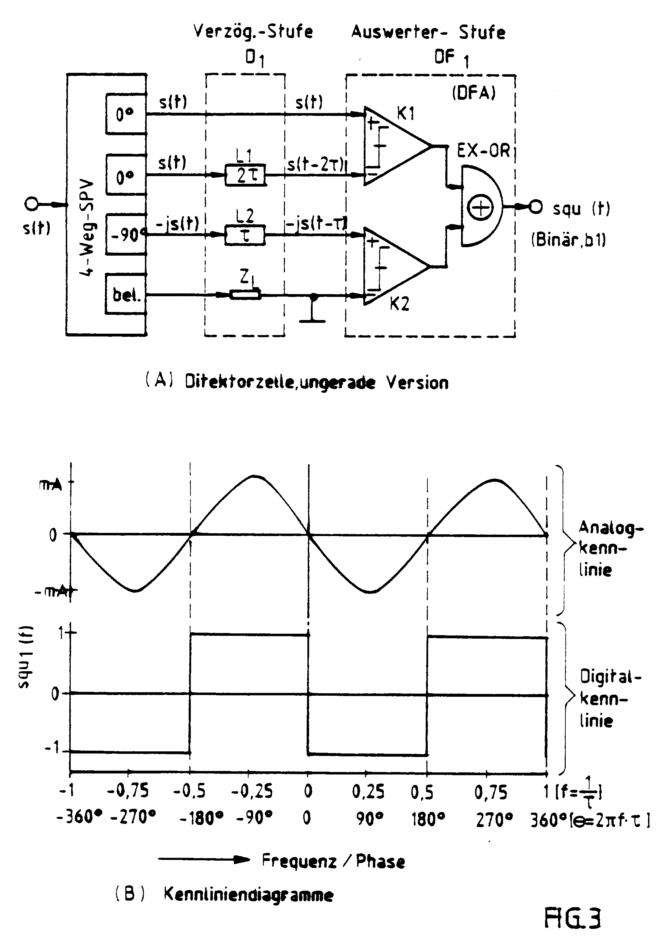

Die Orthogonalität der trigonometrischen Funktionen läßt nun zwei grundsätzliche, verschieden zu dimensionierende Detektorzellen zu, deren Wahl letztlich durch die gewählte Codeart (Gray-Code, Binär-Code) des digitalen Frequenzwertes $z(f)$ bzw. $q(k)$ festgelegt wird. In FIG. 2 wird die gerade Version (z.B. für Gray-Codestelle g2) und in FIG. 3 die ungerade Version (z.B. für die Binär-Codestelle b1) aufgezeigt.

Die einzelnen Detektorzellen $(i = 1...N)$ sind durch spezielle Signalverarbeitungsvorschriften gekennzeichnet, die mit Hilfe der Vorzeichenfunktion sgn und der 1 Bit-Modulo-Addition $\oplus$ für die gerade Version zu

$$sqg_i(t) = \pm \, sgn \, [s(t) + s\,(t\text{-}T_i)] \oplus sgn \, [s(t\text{-}\tfrac{1}{2}T_i)] \qquad (1)$$

und für die ungerade Version zu

$$squ_i(t) = \pm \, sgn \, [s(t)\text{-}s(t\text{-}2T_i)] \oplus sgn \, [\text{-}j \bullet s(t\text{-}T_i)] \qquad (2)$$

angegeben werden können, wobei die codestellenspezifische Verzögerungszeit $T_i$ der i-ten Codestelle (i = Rang der Codestelle, MSB: i = 1) als ganzzahliges Vielfaches des Verzögerungsinkrements $\tau$ nach $T_i = 2^{i-1} \bullet \tau$ bemessen ist. Die zugehörigen Kennlinienfunktionen (Detektionsfunktionen) sind dementsprechend anzugeben mit

a) gerade Version:

$$sqg_i(f) = \mp \, sgn2 \bullet \{cos[\pi f \bullet T_i]\} \qquad (3)$$

b) ungerade Version:

$$squ_i(f) = \mp \, sgn2 \bullet \{sin[2\pi f \bullet T_i]\} \qquad (4)$$

Die doppelten Vorzeichen stehen für die Wahlmöglichkeiten zwischen normaler und invertierter Form. Die Richtigkeit der Gl.(1) bis (4) kann anhand einer einfachen Rechnung für die gerade Detektorzelle mit i = 2 , $T_i = 2\tau$ nach FIG. 2 wie folgt angegeben werden.

Mit den Ansätzen

$$s\,(t) = A \cos (wt), (w = 2\pi f, A = Signalamplitude)$$
$$s\,(t - \tau) = A \cos w\,(t - \tau) = A \cos (wt - \theta),$$
$$s\,(t - 2\tau) = A \cos w\,(t - 2\tau) = A \cos (wt - 2\theta), \qquad (5)$$

wobei für den Laufzeitwinkel $w\tau = \theta$ gesetzt wird, lautet die Gl.(1)

$$sqg_2(t) = \pm \, sgn \, A[cos(wt) + cos(wt\text{-}2\theta)] \oplus sgn \, A[cos(wt\text{-}\theta)] \qquad (6)$$

Um die Gleichung (6) den üblichen algebraischen Rechenoperationen zugänglich zu machen, muß sie noch entsprechend umgeformt werden. Zunächst kann die Modulo-Summation entweder durch eine Division

4

$$sqg_2(t) = \mp \ sgn \left\{ \frac{[cos(wt) + cos\ (wt-2\Theta)]}{cos\ (wt - \Theta)} \right\} \qquad (7)$$

oder durch eine Multiplikation

$$sqg_2(t) = \mp \ sgnA^2 \ \{[cos(wt) + cos(wt-2\theta)] \cdot [cos(wt-\theta)]\} \qquad (8)$$

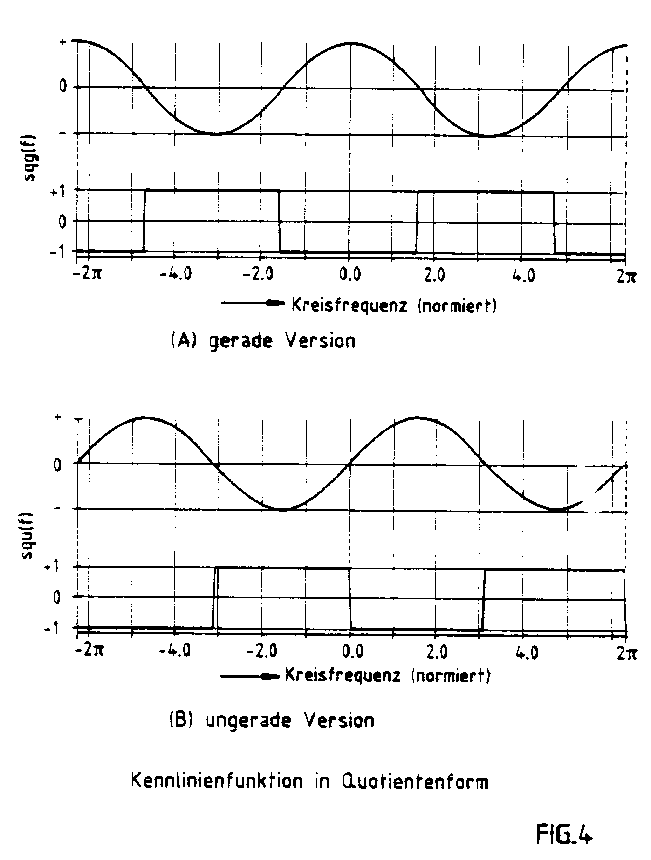

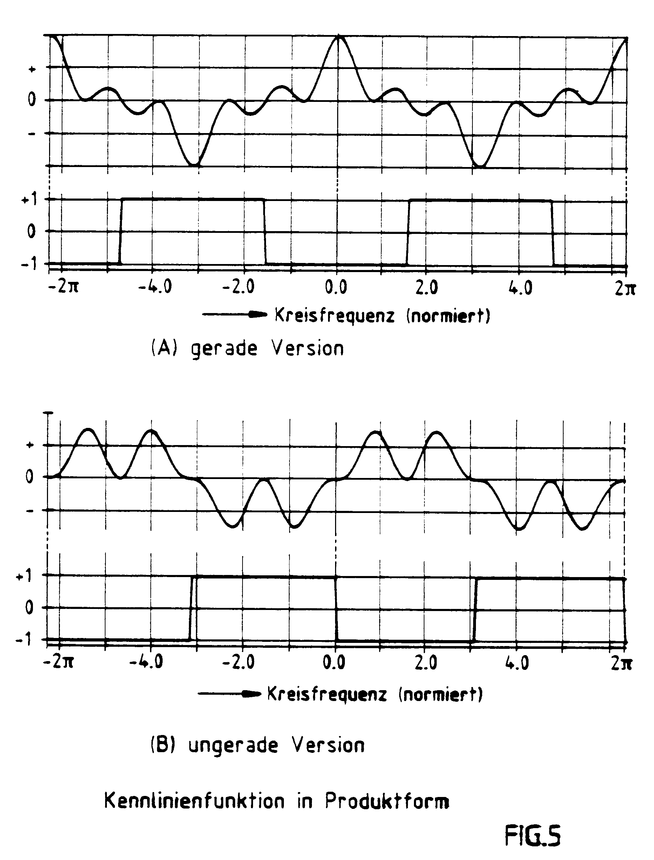

gleichwertig ersetzt werden. Die analogen und digitalen Kennlinienfunktionen zu den beiden Gleichungen (7) und (8) sind in FIG. 4 bzw. 5 sowohl für die gerade Detektorzelle (A) als auch für die ungerade Detektorzelle (B) dargestellt. Daraus ist ersichtlich, daß bezüglich der Vorzeichenoperationen (sgn) die Multiplikationen als auch Divisionen zum gleichen Ergebnis führen.

Es ist wesentlich einfacher bei der Weiterrechnung mit der Divisionsform der Gleichung (7) zu arbeiten. Dies entspricht auch physikalisch dem Demudulationsvorgang $2\pi f = d\rho/dt$. Zur Berechnung der analogen Frequenz-Detektionsfunktion (Kennlinie) sei nur der vorzeichenlose Teil

$$sag(t) = \frac{[cos(wt) + cos\ (wt - 2\Theta)]}{cos\ (wt - \Theta)} \qquad (9)$$

der Gleichung (7) verwandt. Mit Hilfe des Additionstheorems

$$cos\alpha + cos\beta = 2\ cos\ \frac{\alpha+\beta}{2}\ cos\ \frac{\alpha-\beta}{2} \qquad (10)$$

der trigonometrischen Funktion läßt sich der Zähler der Gleichung (9), wobei für $\alpha$ = wt und $\beta$ = wt - 2$\theta$ gesetzt wird, umformen in

$$2cos\ \frac{wt + wt-2\Theta}{2}\ cos\ \frac{wt - wt+2\Theta}{2} = 2cos\ (wt-\Theta) \cdot cos\ (\Theta). \qquad (11)$$

Dies in Gleichung (9) eingesetzt, ergibt die analoge Kennlinie der geraden Detektorzelle zu

$$sag(t) = 2\ \frac{cos(wt-\Theta)\ cos(\Theta)}{cos(wt-\Theta)} = 2cos\ (\Theta) \qquad (12)$$

die jetzt nur noch frequenzabhängig ($\theta$ = $2\pi f\tau$) ist und somit mit dem vorzeichenlosen Teil der Kennliniengleichung (3) identisch ist. Dementsprechend läßt sich auch die Kennlinienfunktion, Gleichung (4), der ungeraden Detektorzelle bestimmen. Nach FIG. 3 und mit den orthogonalen Ansätzen zu den Gleichungen (5) ergibt sich dann hier die zur Gleichung (7) entsprechende Quotientengleichung

$$squ(t) = \mp \; sgn \left\{ \frac{[cos(wt) - cos(wt - 2\Theta)]}{-\; sin \;\; (wt \; - \; \Theta)} \right\} \qquad (13)$$

der ungeraden Detektorzelle. Die Anwendung des gleichen Berechnungsschemas, wie zur Bestimmung der geraden Detektionszelle ausgeführt, auf die Gleichung (13) liefert dann als Ergebnis die analoge Kennlinie

$$sau(t) = -\; 2 \; \frac{sin \;(wt - \Theta) \cdot sin \;(\Theta)}{-sin \;(wt - \Theta)} = 2 \; sin \;(\Theta) \quad (14)$$

der ungeraden Detektorzelle. Damit ist die Dimensionierungsgrundlage sowohl der einzelnen Detektorzellen als auch des gesamten digitalen Momentanfrequenz-Detektor-Verfahrens eindeutig festgelegt. Die FIG. 3 zeigt den prinzipiellen Aufbau (A) und die zugehörigen Kennlinien (analog und digital) für $i = 1$, also $T_i = \tau$ und $\theta = 2\pi f\tau$.

Die in FIG. 1 schematisch zusammengefaßten technischen Ausführungsformen des erfindungsgemäßen Verfahrens beruhen also im wesentlichen auf den technischen Anwendungen der Gleichungen (1) bis (4) und ermöglichen damit extrem schnelle und genaue Momentanfrequenz-Detektionen von kurzzeitigen Signalen bis weit in den GHz-Frequenzbereich (z.B. von Mikrowellenimpulsen). Zur praktischen Realisierung kommen hierbei nur parallele Anordnungen von speziellen Detektorzellen in Frage, die jeweils mit entsprechend phasenverschobenen Eingangssignalen aus einem Signal-Phasen-Verteiler (SPV) versorgt werden müssen. Die Addition zweier Analogsignale kann dabei vorteilhafterweise durch eine Subtraktion in einem Komparator bei gleichzeitiger Durchführung der Vorzeichenbildung ausgeführt werden, indem eines der zu addierenden Signale im SPV um 180° phasengedreht wird.

So stellt bei der in FIG. 2 (A) skizzierten Anordnung für eine Detektorzelle zur Realisierung der geraden Verarbeitungsvorschrift für $i = 2$ (und damit $T_i = 2\tau$) der Signalphasenverteiler SPV aus dem (bandpaßgefilterten) Eingangssignal s(t) vier Signalanteile (entsprechend $s_{21}$ bis $s_{24}$ in FIG. 1) für die Signalverzögerungseinheit zur Verfügung. Gemäß Gleichung (1) werden zwar nur drei verschiedene Signalanteile benötigt, der SPV liefert jedoch bei später noch detaillierter beschriebenem Aufbau für Ausgangssignale ohne gegenseitige Laufzeitdifferenz jeweils einen vierten Signalanteil, der aber nicht weiter ausgewertet wird und dessen Phase daher beliebig ist. Entsprechend dem ersten Modulo-Summanden in Gleichung (1) wird ein erstes Signal unverzögert durch die Signalverzögerungsstufe $D_2$ auf den nicht invertierenden Eingang eines ersten Komparators K1 geführt, an dessen invertierendem Eingang der durch 180°-Phasendrehung im SPV invertierte und in der Verzögerungsstufe $D_2$ durch die Verzögerungsleitung L1 um $T_i = 2\tau$ verzögerte Signalanteil liegt. Durch die doppelte Invertierung des verzögerten Signalanteils erscheint am Ausgang des Komparators K1 das Vorzeichensignal der Signalsumme des ersten Modulo-Summanden der Gleichung (1).

Der zweite Modulo-Summand enthält nur einen Signalanteil. Dieser Signalanteil wird ohne Phasendrehung im SPV in der Verzögerungsstufe durch die Verzögerungsleitung L2 um $\frac{1}{2}T_i = \tau$ verzögert und auf den nicht invertierenden Eingang des zweiten Komparators K2 geführt, dessen invertierender Eingang auf Bezugspotential liegt und dessen Ausgangssignal daher bereits das Vorzeichen dieses Signalanteils darstellt. Im nachgeschalteten EX-OR-Gatter werden die digitalen Ausgangssignale der Komparatoren zu dem Bitwert $sqg_2$ verknüpft, welcher beispielsweise die zweite Kodestelle $g_2$ eines Gray-Codes darstellen kann. Der vierte Ausgang des Signalphasenverteilers ist reflexionsfrei mit dem Wellenwiderstand $Z_L$ abgeschlossen.

In FIG. 2 (B) ist die zugehörige digitale Kennlinie und darüber zum Vergleich die Gleichung (12) entsprechende analoge Kennlinie über der normierten Frequenz bzw. dem entsprechenden Laufzeit-Phasenwinkel $\theta$ für den doppelten Frequenzauflösungsbereich (f = -1 bis +1) aufgetragen.

FIG. 3 (A) zeigt die entsprechende Anordnung einer Detektorzelle zur Realisierung der ungeraden Verarbeitungsvorschrift für $i = 1$ und damit $T_i = \tau$ bei welcher der SPV entsprechend Gleichung (2) neben zwei gleichphasigen Signalanteilen einem um 90° phasenverschobenen Signalanteil an die Verzögerungsstufe $D_1$ abgibt. Das Ausgangssignal squ dieser Detektorzelle bildet beispielsweise das MSB b1 eines Binärcodes für den digitalen Frequenzwert. In FIG. 3 (B) sind wieder der zugehörigen Kennlinien dargestellt.

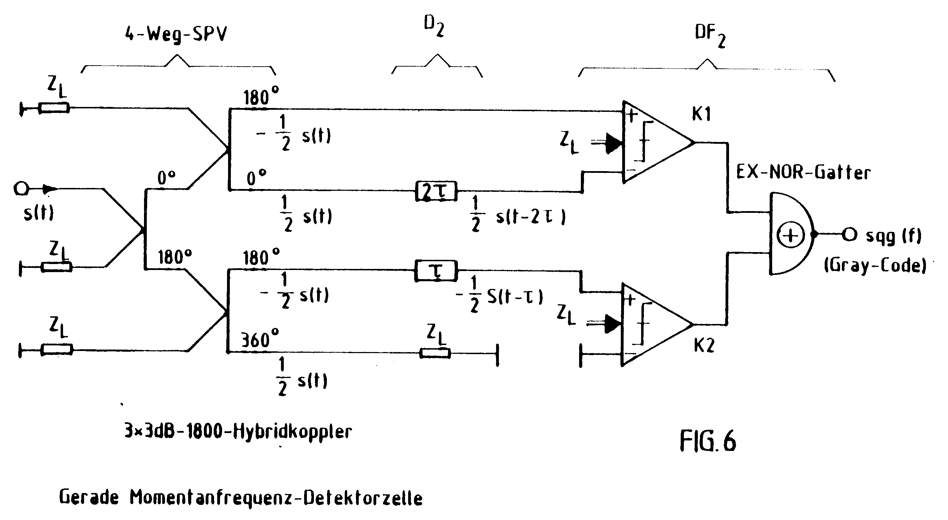

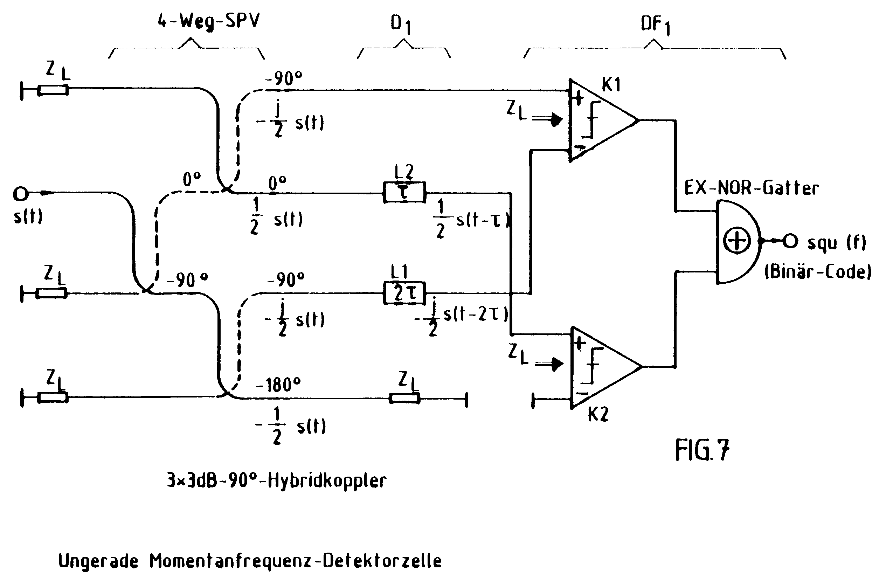

Die FIG. 6 und 7 zeigen vorteilhafte Ausführungsformen mit weiteren Details hinsichtlich der Signalphasenverteiler SPV für die in FIG. 2 (A) und 3 (A) skizzierten Beispiele. Die dabei eingetragenen Phasenwerte weichen teilweise von den Phasenwerten der FIG. 2 (A) und 3 (A) ab, führen aber, wie sich leicht zeigen läßt, zu denselben Ausgangssignalen sq(f). Dies veranschaulicht auch, daß es zur schaltungstechnischen Realisierung der angegebenen Signalverarbeitungsvorschriften verschiedene gleichwertige Wege gibt.

Der 4-Weg-SPV der geraden Momentanfrequenz-Detektorzelle kann nach FIG. 6 sehr einfach mit drei gleichen 3dB-180°-Hybridkopplern aufgebaut werden. Hierbei werden für die Hybridkoppler Ausführungen in Streifenleiter-Technik bevorzugt, die bewährter Stand der Technik sind. Ebenso einfach läßt sich nach FIG. 7 die ungerade Momentanfrequenz-Detektorzelle mit einem 4-Weg-SPV aufbauen, der hier aus drei gleichen 3 dB-90°-Hybridkopplern besteht. Da zur richtigen Funktion der Detektorzellen bestimmte Phasenbeziehungen der Signale innerhalb der Detektorschaltung eingehalten werden müssen, erfolgt die Zusammenschaltung des jeweiligen 4-Weg-SPVs mit der Verzögerungsstufe $D_i$ und der Auswerter-Stufe $DF_i$ gemäß der Gleichung(1) oder (2), wie beispielsweise auch in FIG. 2 (A) bzw. 3 (A) skizziert. Die nicht genutzten Anschlüsse der Koppler sind jeweils mit $Z_L$ reflexionsfrei abgeschlossen.

Mit diesen 1-Bit-Detektorzellen lassen sich nun DMFD-Anordnungen für fast beliebige Wortbreiten N der Frequenzwerte q(k) sowie wahlweise im Binär-Code oder im Gray-Code aufbauen. Anhand von drei Beispielen für 4-Bit-Momentanfrequenz-Detektoren wird dies nun näher erläutert.

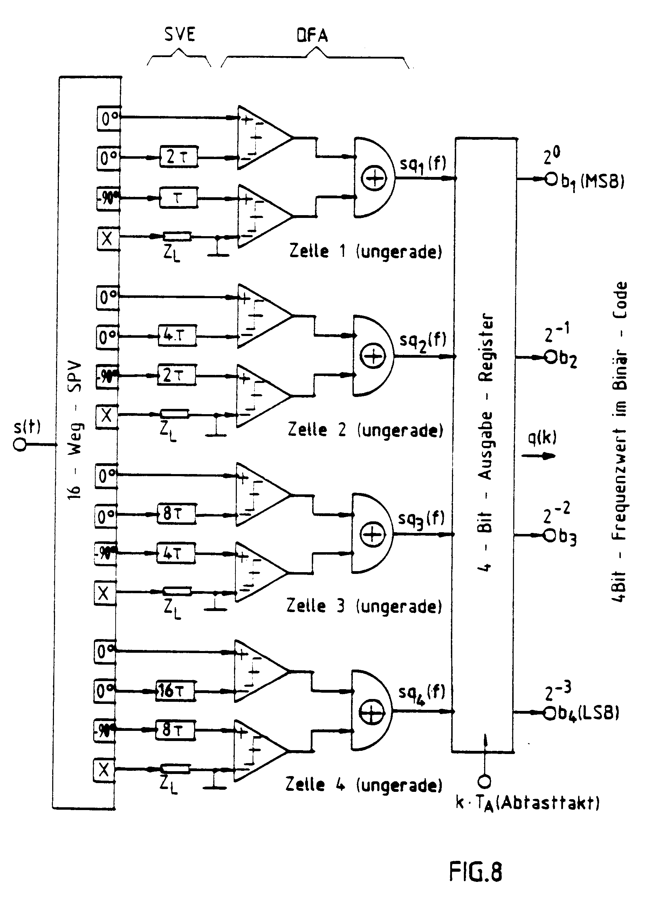

So liefert der nach FIG. 8 aufgebaute 4-Bit-Momentanfrequenz-Detektor den digitalen Frequenzwert q(k) im 4-Bit-Binär-Code. Zusätzlich zum entsprechenden 16-Weg-SPV werden 4 Detektorzellen der ungeraden Version, FIG. 3 oder 7, benötigt, die die DMFD-Funktion in Form der Signal-Verzögerungseinheit SVE zusammen mit dem Digital-Frequenz-Auswerter DFA bezwecken. Als besonderes Merkmal dieser Detektorschaltung ist die Laufzeitstaffelung in 2er-Faktoren für die einzelnen Verzögerungsstufen bzw. Detektorzellen zu beachten. Diese Signalverzögerungs-Bedingungen für die Binär-Code-Darstellung des Frequenzwertes q(k) ergeben sich aus den Kennliniendiagrammen und Binär-Code-Beziehungen zu den einzelnen Kennlinien, die in FIG. 9 aufgezeigt sind. Damit gelten für die einzelnen Detektorzellen folgende Laufzeiten (1. Verzögerungsleitung, 2. Verzögerungsleitung) bezüglich ihrer Codestellen:

Zelle 1 (ungerade) :  $2\tau$, $\tau$ für Binär-Codestelle $b_1$, MSB
Zelle 2 (ungerade) :  $4\tau$, $2\tau$ für Binär-Codestelle $b_2$
Zelle 3 (ungerade) :  $8\tau$, $4\tau$ für Binär-Codestelle $b_3$
Zelle 4 (ungerade) :  $16\tau$, $8\tau$ für Binär-Codestelle $b_4$, LSB

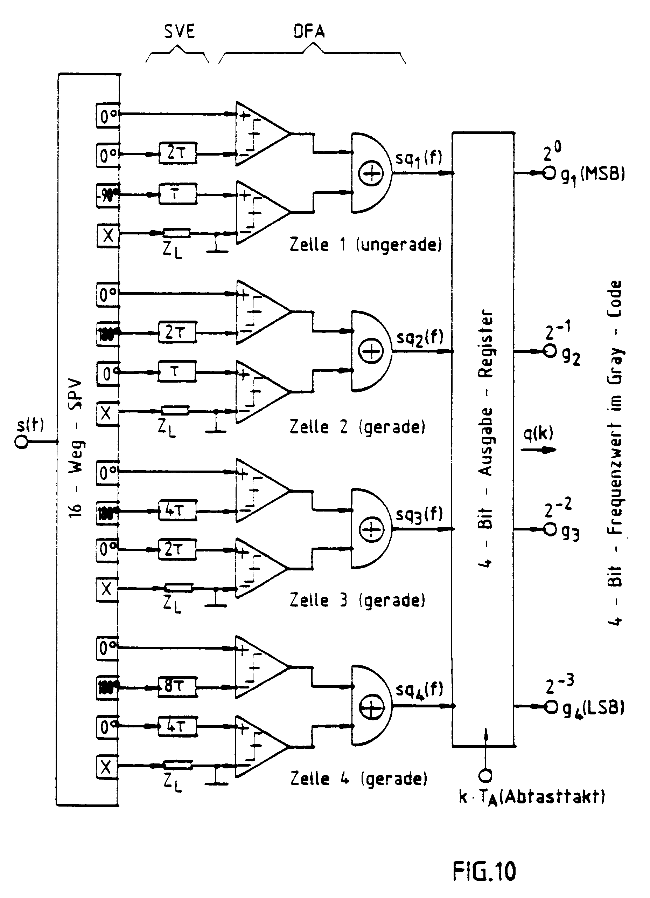

Nach FIG. 10 weist der 4-Bit-Momentanfrequenz-Detektor für die Frequenzwertausgabe q(k) im Gray-Code einen ähnlichen Aufbau auf. Jedoch im Gegensatz zu dem vorher beschriebenen Binär-Code-Detektor einiges anders zu dimensionieren. Der 16-Weg-SPV muß in diesem Fall geänderte Phasenlagen von s(t) an seinen Mehrfachausgängen bereitstellen. Ebenfalls bestehen jetzt die vier einzusetzenden Detektorzellen aus unterschiedlichen Versionen. So ist die Detektorzelle für das höchstwertigste Gray-Code-Bit g1 ($2°$-Wertigkeit) durch eine ungerade Detektorzelle, FIG. 3 oder 7, zu realisieren. Dagegen werden die niederwertigeren Gray-Code-Bits g2 bis g4 ($2^{-1}$ - bis $2^{-3}$-Wertigkeit) durch gerade Detektorzellen nach FIG. 2 oder 6 gewonnen. Anhand von FIG. 11 ergeben sich dann infolge der Kennliniendiagramme für den Gray-Code auch neue Detektor-Signallaufzeiten. Jedoch bleibt die prinzipielle Laufzeitstaffelung mit dem Faktor 2 auch hier enthalten. Dementsprechend sind hier für die einzelnen Detektorzellen folgende Signallaufzeiten bezüglich ihrer Codestellen anzugeben:

Zelle 1 (ungerade) :  $2\tau$, $\tau$ für Gray-Codestelle $g_1$, MSB
Zelle 2 (gerade) :  $2\tau$ $\tau$ für Gray-Codestelle $g_2$
Zelle 3 (gerade) :  $4\tau$, $2\tau$ für Gray-Codestelle $g_3$
Zelle 4 (gerade) :  $8\tau$, $4\tau$ für Gray-Codestelle $g_4$, LSB

Damit ist im Gegensatz zum Binär-Code-Frequenzdetektor die maximale Laufzeit des Gray-Code-Frequenzdetektors nur halb so groß (hier $8\tau$ anstatt $16\tau$).

Am Ausgang der beiden 4-Bit-Momentanfrequenz-Detektoren für die Frequenzwertausgaben, sowohl im Binär-Code als auch Gray-Code, ist dann noch das übliche 4-Bit-Ausgabe-Register zur Datensynchronisation auf den Abtasttakt $K \bullet T_A$ vorzusehen.

Außer diesen beschriebenen DMFD-Varianten (entweder für Binär-Code-oder Gray-Code-Darstellung der Frequenzwerte q(k)) sind prinzipiell auch andere Kodierungen möglich. Hiervon dürfte aber für die technische Realisierung im wesentlichen nur eine Version mit der Frequenzwertausgabe im Binär-Gray-Mischcode wie nachstehend noch beschrieben interessant sein.

Anhand von Bild 12 wird ein solches Beispiel eines 4-Bit-DMFDs aufgezeigt. Nach Bild 13 ergeben sich damit für die einzelnen Detektorzellen bezüglich ihrer Codeart und Codestellen und jeweils für ihre erste und zweite Verzögerungsleitung folgende Signallaufzeiten:

Zelle 1 (ungerade) :  $2\tau$, $\tau$ für Binär-Codestelle $b_1$, MSB
Zelle 2 (gerade) :  $2\tau$, $\tau$ für Gray-Codestelle $g_2$

Zelle 3 (ungerade) :     $8\tau$, $4\tau$ für Binär-Codestelle $b_3$

Zelle 4 (gerade) :       $8\tau$, $4\tau$ für Gray-Codestelle $g_4$, LSB

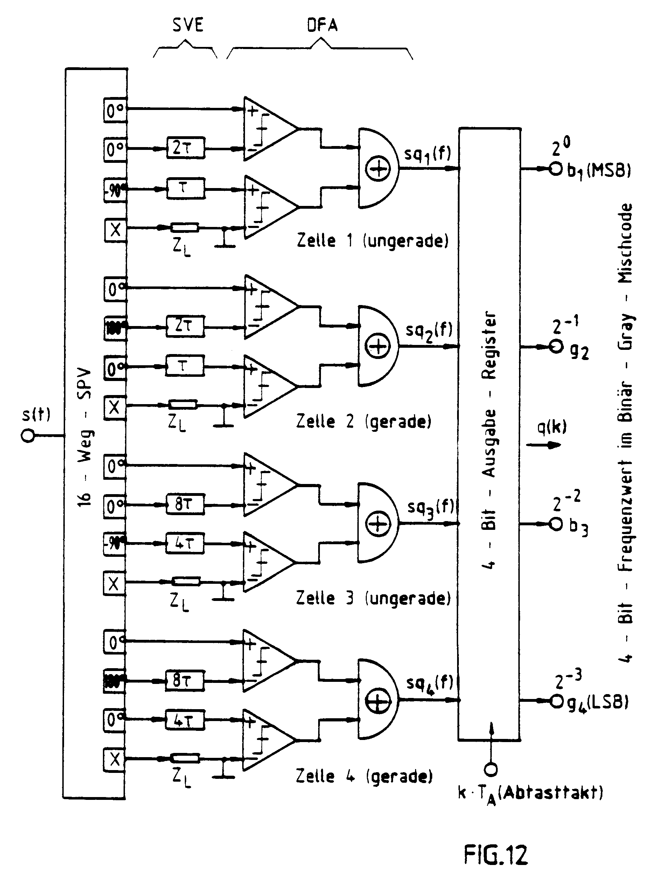

In diesem Fall treten in der Reihenfolge vom höchstwertigsten Bit (MSB) zum niederwertigsten Bit (LSB) die ungeraden mit den geraden Detektorzellen abwechselnd auf. Auch sind hier die inneren Signallaufzeiten bezüglich der Detektorzellen paarweise gleich. Dies bedingt nun für die technische Realisierung eine vorteilhafte Signallaufzeitstaffelung um den Faktor 4 für die einzelnen Paare von Detektorzellen, die sich jeweils aus einer ungeraden und einer geraden Zelle mit gleichen inneren Signallaufzeiten zusammensetzen. Damit reduziert sich für solche DMFDs bei Wortbreiten N > 4 Bit der Aufwand an unterschiedlich gestuften Verzögerungsleitungen erheblich. Dieser Vorteil wird aber durch den erzeugten Binär-Gray-Mischcode etwas beeinträchtigt, der in der Regel so nicht weiterverarbeitet werden kann. Jedoch ist dieser Mischcode sehr einfach durch EX-OR/NOR-Verknüpfungen (hier durch das $\oplus$ -Symbol dargestellt) in den Binär-Code oder in den Gray-Code überzuführen. Im Fall des 4-Bit-Momentanfrequenz-Detektors nach FIG. 12 und 13 ergeben sich dann folgende logische Umcodiervorschriften:

a) für den Mischcode in Binär-Code:

$b_1 = b_1$

$b_2 = g_2 \oplus b_1$

$b_3 = b_3$

$b_4 = g_4 \oplus b_3$

b) für den Mischcode in Gray-Code:

$g_1 = b_1$

$g_2 = g_2$

$g_3 = b_1 \oplus g_2 \oplus b_3$

$g_4 = g_4$

Ebenfalls erfolgt hier, wie bei den vorher beschriebenen beiden Grundversionen, die Datenausgabe zweckmäßigerweise über ein Register.

## Patentansprüche

1. Verfahren zur Bestimmung der Momentanfrequenz eines zeitveränderlichen Signals s(t) innerhalb eines Frequenzbereichs vorgegebener Bandbreite ($\Delta f$) unter Einsatz von Signalverzögerungen von ganzzahligen Vielfachen eines Verzögerungsinkrements $\tau$ und Kodierung der Momentanfrequenz als digitalen Frequenzwert mit N Bitstellen, dadurch gekennzeichnet, daß die Bitwerte $sq_i$ der verschiedenen Codestellen $i = 1...N$ des digitalen Codes getrennt parallel ermittelt werden, daß die $sq_i$ bei Codestellen mit bezüglich der Kodierbereichsmitte gerader Bitfunktion nach der geraden Vorschrift

$$sqg_i(t) = sgn[s(t) + s(t-T_i)] \oplus sgn [ s(t-\tfrac{1}{2}T_i)]$$

und bei Codestellen mit bezüglich der Kodierbereichsmitte ungerader Bitfunktion nach der ungeraden Vorschrift

$$squ_i(t) = sgn [s(t) - s(t-2T_i)] \oplus [sgn -j \bullet s(t-T_i)]$$

ermittelt werden, wobei "sgn" die Vorzeichenfunktion Signum, "$\oplus$" die 1-Bit-Modulo-Addition, s das unverzögerte bzw. verzögerte zeitveränderliche Signal, $T_i$ eine Signalverzögerung der Größe $T_i = 2^{i-1} \bullet \tau$ und j eine 90°-Phasenverschiebung des Signals repräsentieren.

2. Verfahren nach Anspruch 1, dadurch gekennzeichnet, daß die Bitwerte $sq_i = sqg_i$ oder $squ_i$ niederfrequent abgetastet werden.

3. Anordnung zur Durchführung des Verfahrens nach Anspruch 1, dadurch gekennzeichnet, daß ein Signalphasenverteiler (SPV) und für jede Kodestelle eine eigene von mehreren (N) Detektorzellen mit jeweils einer Verzögerungseinheit ($D_i$) und einer Auswerterstufe ($DF_i$) vorgesehen ist, daß der Signalphasenverteiler aus dem zeitveränderlichen Signal mehrere Signalanteile definierter gegenseitiger Phasenlage ableitet, daß die Verzögerungseinheit die Signalanteile um die jeweils vorgeschriebenen relativen Verzögerungszeiten verzögert und die Auswertestufe durch Amplitudenvergleich, Vorzeichenbildung und 1-Bit-Modulo-Addition den Bitwert der jeweiligen Kodestelle am Ausgang der Detektorstufe abgibt.

**4.** Anordnung nach Anspruch 3, dadurch gekennzeichnet, daß der Signalphasenverteiler (SPV) mehrere 3dB-Hybridkoppler enthält.

**5.** Anordnung nach Anspruch 3, dadurch gekennzeichnet, daß die Verzögerungseinheit ($D_i$) jeder Detektorzelle drei Signalwege mit um gleiche Differenzbeträge gestaffelten Laufzeiten enthält.

**6.** Anordnung nach Anspruch 3, dadurch gekennzeichnet, daß die Auswertestufe zwei Komparatoren und ein EX-OR- oder ein EX-NOR-Gatter zur Realisierung der sgn-Funktionen und der 1-Bit-Modulo-Addition enthält.

## Claims

**1.** Method for determining the instantaneous frequency of a signal s(t), which is variable as a function of time, within a frequency range of preset bandwidth ($\Delta f$) with the use of signal delays of integral multiples of a delay increment $\tau$ and coding of the instantaneous frequency as digital frequency value with N bit places, characterised thereby, that the bit values $sq_i$ of the different code places i = 1 to N of the digital code are separately ascertained parallelly, that the $sq_i$ are ascertained according to the even instruction

$$sqg_i(t) = sgn[s(t) + s(t-T_i)] \oplus sgn\ [s(t-\tfrac{1}{2}T_i)]$$

at code places of even bit function with respect to the centre of the coding range, and according to the odd instruction

$$squ_i(t) = sgn\ [s(t) - s(t-2T_i)] \oplus [sgn\ -j.s(t-T_i)]$$

at code places of odd bit function with respect to the centre of the coding range, wherein "sgn" represents the sign function Signum, "$\oplus$" the 1-bit-module-addition, s the undelayed or the delayed signal which is variable as a function of time, $T_i$ a signal delay of the magnitude $T_i = 2^{i-1}.\tau$ and j represents a 90° phase shift of the signal.

**2.** Method according to claim 1, characterised thereby, that the bit values $sq_i = sqg_i$ or $squ_i$ are scanned at low frequency.

**3.** Arrangement for the performance of the method according to claim 1, characterised thereby, that a signal phase distributor (SPV) is provided, an individual one of several (N) detector cells each with a respective delay unit ($D_i$) and a respective evaluating stage ($DF_i$) is provided for each code place, that the signal phase distributor derives several signal components of defined relative phase position from the signal which is variable as a function of time, that the delay unit delays the signal components by the respectively prescribed relative delay times and the evaluating stage delivers the bit value of the respective code place at the output of the detector stage through amplitude comparison, sign formation and 1-bit-module-addition.

**4.** Arrangement according to claim 3, characterised thereby, that the signal phase distributor (SPV) contains several 3dB hybrid couplers.

**5.** Arrangement according to claim 3, characterised thereby, that the delay unit ($D_i$) of each detector cell contains three signal paths with transit times staggered by equal amounts of difference.

**6.** Arrangement according to claim 3, characterised thereby, that the evaluating stage contains to comparators and an EX-OR gate or an EX-NOR gate for the realisation of the sgn functions and 1-bit-module-addition.

## Revendications

**1.** Procédé de détermination de la fréquence instantanée d'un signal variant dans le temps s(t) à l'intérieur d'une plage de fréquence de largeur prédéterminée ($\Delta f$) utilisant des temporisations du signal selon des multiples entiers d'un incrément de temporisation $\tau$ et de codage de la fréquence instantanée sous la forme d'une valeur numérique de fréquence sur n positions binaires, caractérisé en ce que les valeurs binaires $sq_i$ des différentes positions i = 1...n du code numérique sont déterminées individuellement en parallèle, en ce que les valeurs binaires $sq_i$, dans le cas de fonctions binaires paires par rapport au centre du domaine de codage, sont déterminées par la règle paire

$$sqg_i(t) = sgn\ [s(t) - s(t\text{-}T_i)] \oplus sgn\ [s(t - 1/2T_i)]$$

et, dans le cas de fonctions binaires impaires par rapport au centre du domaine de codage, par la règle impaire,

$$squ_i(t) = sgn\ [s(t) - s(t\text{-}2T_i)] \oplus [sgn\ \text{-}j.s(t\text{-}\ T_i)]$$

où "sgn" désigne la fonction de signe Signum, "$\oplus$" l'addition modulo sur 1 bit, s le signal variable dans le temps, temporisé ou non temporisé, $T_i$ une temporisation du signal de grandeur $T_i = 2^{i\text{-}1}.\tau$ et j un déphasage de 90° du signal.

**2.** Procédé selon la revendication 1, caractérisé en ce que les valeurs binaires $sq_i = sqg_i$ ou $sgu_i$ sont échantillonnées à basse fréquence.

**3.** Dispositif de mise en oeuvre du procédé selon la revendication 1, caractérisé en ce qu'il est prévu un distributeur de phases de signal (SPV) et une cellule de détection propre à chaque position du code parmi n cellules de détection composées chacune d'une unité de temporisation ($D_i$) et d'une unité de traitement ($DF_i$), en ce que le distributeur de phases dérive du signal variable dans le temps plusieurs composantes de signal dont la phase réciproque est déterminée, en ce que l'unité de temporisation retarde les composantes du signal des durées de temporisation relatives prescrites et en ce que l'étage de traitement forme la valeur binaire de la position de code considérée par comparaison d'amplitude, calcul du signe et addition modulo sur 1 bit pour la fournir à la sortie de la cellule de détection.

**4.** Dispositif selon la revendication 3, caractérisé en ce que le distributeur de phases (SPV) comporte plusieurs coupleurs hybrides 3 dB.

**5.** Dispositif selon la revendication 3, caractérisé en ce que l'unité de temporisation ($D_i$) de chacune des cellules de détection comporte trois trajets de signal avec des temps de propagation décalés de valeurs différentielles égales.

**6.** Dispositif selon la revendication 3, caractérisé en ce que l'étage de traitement comporte deux comparateurs et une porte OU exclusif ou NON-OU exclusif pour réaliser les fonctions sgn et l'addition modulo sur 1 bit.

FIG. 1

(A)   Detektorzelle, gerade Version

(B)   Kennliniendiagramme

FIG.2

(A) Ditektorzelle, ungerade Version

(B) Kennliniendiagramme

FIG.3

(A) gerade Version

(B) ungerade Version

Kennlinienfunktion in Quotientenform

FIG.4

14

(A) gerade Version

(B) ungerade Version

Kennlinienfunktion in Produktform

FIG.5

4-Weg-SPV

$D_2$

$DF_2$

$Z_L$

$180°$

$-\frac{1}{2} s(t)$

$0°$

$0°$

$Z_L$

$\frac{1}{2} s(t)$

$2\tau$

$\frac{1}{2} s(t-2\tau)$

$Z_L$

$s(t)$

$Z_L$

$180°$

$180°$

$-\frac{1}{2} s(t)$

$\tau$

$-\frac{1}{2} s(t-\tau)$

$Z_L$

$Z_L$

$360°$

$Z_L$

$\frac{1}{2} s(t)$

K1

EX-NOR-Gatter

$+$

sqg (f)
(Gray-Code)

K2

$3 \times 3dB - 1800 - Hybridkoppler$

FIG. 6

Gerade Momentanfrequenz-Detektorzelle

EP 0 313 765 B1

FIG.7

FIG.8

(A) Kennliniendiagramme der einzelnen 1-Bit-Zellen

(B) Binär-Code-Beziehungen zu den Kennlinien

FIG.9

FIG.10

EP 0 313 765 B1

20

(A) Kennliniendiagramme der einzelnen 1-Bit-Zellen

(B) Gray-Code-Beziehungen zu den Kennlinien

FIG.11

FIG.12

(A) Kennliniendiagramme der einzelnen 1-Bit-Zellen

(B) Mischcode-Beziehungen zu den Kennlinien

FIG.13